# EUROPEAN PATENT APPLICATION

(11) **EP 4 611 022 A1**
(43) Date of publication of application: **03.09.2025**
(21) Application number: 24160637.5
(22) Date of filing: 29.02.2024
(51) Int. Cl.: H01L 21/3213, H01L 21/465, C23F 4/00

(54) **PLASMA ETCHING METHOD**

(71) Applicant: IMEC VZW, 3001 Leuven (BE); Katholieke Universiteit Leuven KU Leuven Research & Development, 3000 Leuven (BE)
(72) Inventor: FATHZADEH, Atefeh, 3001 Heverlee (BE); BEZARD, Philippe, 3000 Leuven (BE)
(74) Representative: Winger

(57) **Abstract**

A method for dry etching a compound comprising at least two metals involves injecting reactants and a carrier gas into an etching chamber containing the compound, where each metal can be etched by a plasma of at least one reactant. The method includes stopping the injection of one or more reactants to reduce their concentration having a plasma ignited within the chamber during this decrease.

## Description

### Field of the Invention

The present invention relates to the field of metal etching methods, specifically to a method and system for dry etching compounds containing multiple metals.

### Background of the Invention

Plasma-based dry-etching is a critical technology in the semiconductor industry, enabling the precise patterning of materials for the fabrication of integrated circuits and other advanced electronic devices. The process involves the use of a plasma to generate chemically reactive species that can selectively remove material from a substrate, typically a semiconductor wafer. Plasmas are rich in electrons, which play a pivotal role in the dissociation of gas molecules into highly reactive radicals and the ionization of some of these molecules. These radicals are far more reactive than their stable molecular counterparts, making them effective for etching applications.

Dry etching relies on the formation of volatile products through the reaction of neutral molecules from the plasma with the surface atoms of the material being etched.

An additional synergy in plasma-based dry-etching is the energetic ion bombardment of the surface, which breaks material bonds and mixes plasma and material atoms in an exchange layer that is typically a few nanometers thick.

Metal compounds, by their nature, comprise multiple metals, which can sometimes exhibit superior properties compared to their individual constituents. This is why there is a strong interest in using and patterning metal compounds. However, each metal of the compound reacts at a different rate with the incoming species, which can lead to dramatic slowdowns in the etching process or even complete blocking of further etching. This is depicted in Figs. 1 to 4. The etching rate is typically limited by the component with the slowest reaction rate. For example, in a compound with elements A, B, and C (see Fig. 1), if element A is rapidly etched, it can leave behind a surface primarily composed of elements Band C (see Fig. 2). If element C does not form volatile products and must be sputtered away, it can accumulate on the wafer's surface, impeding the etching process (see Fig. 3).

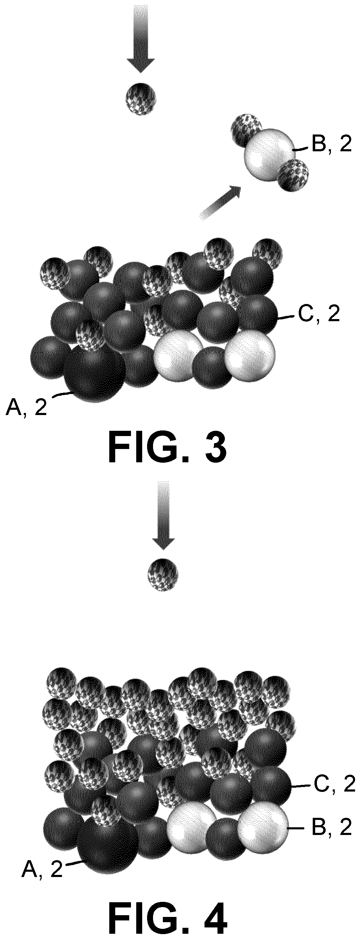

In the case of compounds like In Ga Zn O where Ga can be etched with chlorine but not In (at low temperature), or MgₓZn₁₋ₓO, where zinc can be etched with chlorine, but MgO is insensitive to it, or NiAl, where nickel can be etched with CO, but aluminum cannot, the etching process becomes even more complex. The introduction of other gases can lead to deposition rather than etching (see Fig. 4), further complicating the process.

Despite the advancements in dry-etching technology, there remains a need for further improvements to address the challenges associated with etching compounds composed of multiple metals with different reaction rates.

### Summary of the Invention

It is an object of embodiments of the present invention to enable good control on etching rates of compounds comprising multiple metals. This objective is accomplished by a method and a system for dry etching a compound containing at least two metals according to the invention.

In the first aspect, the present invention relates to a method for dry etching a compound comprising at least two metals, the method comprising: a. Injecting one or more reactants and a carrier gas into an etching chamber comprising the compound, wherein each of the metals can be etched by a plasma of at least one of said reactants, b. Stopping the injection of at least one of said reactants, thereby causing the decrease of the concentration of said reactant, and c. Igniting a plasma within the etching chamber for a time period such that the plasma is present during said decrease. This provides the advantage of enabling simultaneous control over the etching rates of multiple metals.

In embodiments, the one or more reactants may be two or more reactants. This embodiment provides the advantage of allowing for more precise control over the etching process.

In embodiments, where two or more reactants are injected in step a., step b. may consist in stopping the injection of at least two of the reactants, thereby causing the decrease of each of the concentrations of said at least two of the reactants, and wherein step c. may consist in igniting the plasma within the etching chamber for a time period such that the plasma is present during each of said decreases. This embodiment provides the advantage of enabling even more control over the etching rates of multiple metals.

In embodiments, the ignition of the plasma may be started within a time window extending from 500 ms before and 500 ms after, preferably from 250 ms before and 250 ms after, more preferably from 100 ms before and 100 ms after, the stopping of the injection of one of the reactants during step b. For instance, the injection of one of the reactants can be stopped at the same time as the ignition of the plasma is started. Stopping the injection of one of the reactants approximatively at the same as when the plasma is started frequently give good results.

In embodiments, the gas injection of each reactant may be maintained for a period of at least 10 ms, more preferably at least 50 ms, and even more preferably at least 100 ms. This preference is due to the fact that longer gas injection times are more reproducible, which lead to better control of the etching process.

As used herein and unless provided otherwise, when the etching rate of a metal in presence of its primary reactant is envisioned, this etching rate can be the etching rate in presence of only said primary reactant or, alternatively, the etching rate in presence of all reactants, including said primary reactant.

In embodiments, the flow rates of each of the two or more reactants during their injection period may be determined based on the etching rates of each metal in the presence of its primary reactant, i.e., in presence of the reactant most responsible for its etching rate, when the plasma is ignited.

In embodiments, the flow rates of each of the two or more reactants during their injection period may be determined based on the etching rates of each metal in the presence of its primary reactant, i.e., in presence of the reactant most responsible for its etching rate, when the plasma is ignited, such that the primary reactant of the metal having the highest of said etching rate is injected at the lowest flow rate, and the flow rates increase for primary reactants of metals having successively lower etching rates. This fine-tuning of the reactant flow rates is especially effective at balancing the etching rates of different metals when each reactant is the primary reactant of only one metal. Proceeding this way tends to give a more equal etching rate between the different metals of the compound.

In embodiments, the partial pressure achieved during step a for each of the two or more reactants during their injection period may be determined based on the etching rates of each metal in the presence of its primary reactant when the plasma is ignited.

In embodiments, the partial pressure achieved during step a for each of the two or more reactants during their injection period may be determined based on the etching rates of each metal in the presence of its primary reactant when the plasma is ignited, such that the primary reactant of the metal having the highest etching rate in presence of its primary reactant is injected so as to achieve the lowest partial pressure amongst the reactants, and the partial pressures increase for primary reactants of metals having successively lower etching rates in presence of their respective primary reactants. This fine-tuning of the reactant partial pressures is especially effective at balancing the etching rates of different metals when each reactant is the primary reactant of only one metal. Proceeding this way tends to give a more equal etching rate between the different metals of the compound.

In embodiments, the timing of step b may be determined based on the etching rates of each metal in the presence of its primary reactant when the plasma is ignited .

In embodiments, the timing of step b may be determined based on the etching rates of each metal in the presence of its primary reactant when the plasma is ignited, such that the primary reactant of the metal having the highest of said etching rates is stopped the earliest and the stopping time increases for primary reactants of metals having successively lower said etching rates. This fine-tuning of the reactant stopping times is especially effective at balancing the etching per cycle achieved for different metals when each reactant is the primary reactant of only one metal. Proceeding this way tends to give a more equal etching rate between the different metals of the compound.

In embodiments, the determination of the partial pressure during step a for each of the two or more reactants during their injection period, as well as the timing of step b, may be based on the etching rates of each metal in the presence of its primary reactant when the plasma is ignited.

In embodiments, the determination of the partial pressure during step a for each of the two or more reactants during their injection period, as well as the timing of step b, may be based on the etching rates of each metal in the presence of its primary reactant when the plasma is ignited so that the primary reactant of the metal with the highest of said etching rates is injected to achieve the lowest partial pressure amongst the reactants, and the partial pressures for primary reactants of metals with successively lower said etching rates are increased accordingly and so that the primary reactant for the metal with the highest of said etching rates is stopped the earliest during step b, with the stopping time progressively increasing for primary reactants of metals with successively lower etching rates in presence of their respective primary reactants. This fine-tuning is especially effective at balancing the etching per cycle achieved for different metals when each reactant is the primary reactant of only one metal.

In embodiments where at least one of the reactant is the primary reactant for two or more metals, the flow rate of each of the other reactants during their injection period is preferably set to be lower than for said at least one reactant being the primary reactant for two or more metals. The relative magnitude of the flow rates of each of said other reactants during their injection period may be determined based on the etching rates of each metal for which said other reactants are the primary reactants, when the plasma is ignited, such that the primary reactant of the metal having the highest of said etching rate is injected at the lowest flow rate, and the flow rates increase for primary reactants of metals having successively lower etching rates. This fine-tuning of the reactant flow rates is especially effective at balancing the etching rates of different metals when at least one of the reactant is the primary reactant for two or more metals. Proceeding this way tends to give a more equal etching rate between the different metals of the compound.

In embodiments where at least one of the reactant is the primary reactant for two or more metals, the partial pressure achieved during step a for each of the other reactants during their injection period is preferably set to be lower than for said at least one reactant being the primary reactant for two or more metals. The relative magnitude of the partial pressure of each of said other reactants during their injection period may be determined based on the etching rates of each metal for which said other reactants are the primary reactants, when the plasma is ignited, such that the primary reactant of the metal having the highest etching rate in presence of its primary reactant is injected so as to achieve the lowest partial pressure amongst the reactants, and the partial pressures increase for primary reactants of metals having successively lower etching rates in presence of their respective primary reactants. This fine-tuning of the reactant partial pressures is especially effective at balancing the etching rates of different metals when at least one of the reactant is the primary reactant for two or more metals. Proceeding this way tends to give a more equal etching rate between the different metals of the compound.

In embodiments where at least one of the reactant is the primary reactant for two or more metals, the timing of step b for each of the other reactants is preferably set to be earlier than for said at least one reactant being the primary reactant for two or more metals. The timing of step b for each of said other reactants may be determined based on the etching rates of each metal for which said other reactants are the primary reactants, when the plasma is ignited, such that the primary reactant of the metal having the highest of said etching rates is stopped the earliest and the stopping time increases for primary reactants of metals having successively lower said etching rates. This fine-tuning of the reactant stopping times is especially effective at balancing the etching per cycle achieved for different metals when at least one of the reactant is the primary reactant for two or more metals. Proceeding this way tends to give a more equal etching rate between the different metals of the compound.

In embodiments where at least one of the reactant is the primary reactant for two or more metals, the determination of the magnitude of the partial pressure during step a for each of the two or more reactants during their injection period, as well as the timing of step b, may be such that the partial pressure achieved during step a for each of the other reactants during their injection period is set to be lower than for said at least one reactant being the primary reactant for two or more metals and so that the timing of step b for each of the other reactants is preferably set to be earlier than for said at least one reactant being the primary reactant for two or more metals. The determination of the magnitude of the partial pressure during step a and the timing of step b for the other reactants may be based on the etching rates of each metal for which said other reactants are the primary reactants, when the plasma is ignited, so that the primary reactant of the metal with the highest of said etching rates is injected to achieve the lowest partial pressure amongst said other reactants, and the partial pressures for primary reactants of metals with successively lower said etching rates are increased accordingly and so that the primary reactant for the metal with the highest of said etching rates is stopped the earliest during step b, with the stopping time progressively increasing for primary reactants of metals with successively lower etching rates in presence of their respective primary reactants. This fine-tuning is especially effective at balancing the etching per cycle achieved for different metals when at least one of the reactant is the primary reactant for two or more metals. Proceeding this way tends to give a more equal etching rate between the different metals of the compound.
In embodiments, the timing of step b may be determined based on the etching rates of each metal (2) in the presence of its primary reactant (3) when the plasma is ignited, such that: -If each primary reactant is the primary reactant for only one metal, the primary reactant (3) of the metal having the highest of said etching rates is stopped the earliest and the stopping time increases for primary reactants (3) of metals (2) having successively lower said etching rates, and - if at least one of the reactant is the primary reactant for two or more metals, the timing of step b for each of the other reactants is preferably set to be earlier than for said at least one reactant being the primary reactant for two or more metals, and the timing of step b for each of said other reactants may be determined based on the etching rates of each metal for which said other reactants are the primary reactants, when the plasma is ignited, such that the primary reactant of the metal having the highest of said etching rates is stopped the earliest and the stopping time increases for primary reactants of metals having successively lower said etching rates.
In embodiments, the magnitude of the flow rates of the two or more reactants (3) during their injection period may be determined based on the etching rates of each metal (2) in the presence of the reactant (3) most responsible for its etching rate when the plasma is ignited, such that:
- If each primary reactant is the primary reactant for only one metal, the reactant (3) most responsible for the etching rate of the metal (2) having the highest etching rate is injected at the lowest flow rate, and the flow rates increase for reactants (3) most responsible for the etching rate of metals (2) having successively lower etching rates, and
- if at least one of the reactant is the primary reactant for two or more metals, the flow rate of each of the other reactants during their injection period is preferably set to be lower than for said at least one reactant being the primary reactant for two or more metals, and the relative magnitude of the flow rates of each of said other reactants during their injection period may be determined based on the etching rates of each metal for which said other reactants are the primary reactants, when the plasma is ignited, such that the primary reactant of the metal having the highest of said etching rate is injected at the lowest flow rate, and the flow rates increase for primary reactants of metals having successively lower etching rates.

In embodiments, the method may further comprise a step p, before step a of determining the relative etching rates of each metal in the presence of its primary reactant when the plasma is ignited. In other words, the method may further comprise a step p, before step a of determining the relative etching rates of each metal in the presence of the reactant most responsible for its etching when the plasma is ignited. This step is optional because the behavior of each metal in presence of its primary reactant when the plasma is ignited may be known from the scientific literature or from past experience. However, this embodiment provides the advantage of enabling a more informed approach to the etching process by better understanding the etching rates beforehand, which could lead to better results.

In embodiments, each reactant which injection is stopped in step b may be injected in step a at a gas flow of from 0.1 sccm to 1500 sccm, preferably from 0.5 sccm to 500 sccm, more preferably from 1 sccm to 200 sccm, yet more preferably from 2 sccm to 50 sccm. A maximum of 50 sccm is advantageous to limit the movement of pressure regulating valves.

In embodiments, the compound may be amorphous. Although the present invention is useful for all kinds of structures, including crystalline structures, amorphous compounds are advantageous, especially when the thickness of the material layer is relatively low, such as less than 10 nm. The present invention is advantageous for all metal compounds and for all thickness. However, because it is plasma-based, the method will nevertheless inflict minor damage, amounting to a few angstroms or nanometers, to the crystalline lattice of materials. This becomes more problematic when dealing with crystalline material layers that are only a few nanometers thick.

In embodiments, the compound may form a layer which is at least 10 nm thick and is crystalline.

In embodiments, the compound may form a conductive element of a semiconductor device. This is the field where most applications of the present invention will be found. It must be noted, however, that the present invention is equally useful for semiconducting or dielectric compounds.

In embodiments, the conductive element may be a metal interconnect, e.g., for a < 2nm node. The present invention is particularly suitable for advanced semiconductor technology nodes.

In embodiments, the semiconductor device may be a Memory (e.g., MRAM, FeRAM, RRAM, spin-torque, etc.), or a quantum computing device. The universal nature of the present invention makes it applicable in a wide range of cutting-edge applications, including in, but not limited to, these applications.

In embodiments, the conductive element may be a superconductor. This is another example where the versatility of the present invention permits to use it at the front end of the technological trend.

In embodiments, the compound may be a metal alloy. Although the present invention can be adapted to be useful with non-metal elements of a compound, e.g., in the case of Weyl semi-metals such as TaAs, it is surprisingly particularly efficient in the case of metals. The best results are obtained in the case of metal alloys.

However, the invention is applicable to compounds also comprising non-metal elements. Non limiting examples of compounds that can be advantageously etched by the present invention are MgₓZn₁₋ₓO, InₓGa_{z}ZnₒO_{y}, MAX-phase materials such as CrₓAl₁₋ₓC, or superconductors such as NbTiN.

In embodiments, the etching process may be conducted in cycles, with each cycle comprising steps a. through c. This embodiment enables better control and uniformity of etching. Indeed, shorter but repeated steps give better results than a single, not repeated process with longer etching times.

In embodiments, each cycle may remove less than 1 nm of the compound. This embodiment provides the advantage of enabling the best etching performances.

In the second aspect, the present invention relates to a system for dry etching a compound comprising at least two metals, the system comprising: i. An etching chamber configured to receive the compound; ii. A gas delivery system configured to inject one or more reactants and a carrier gas into the etching chamber; iii. A plasma generation system configured to ignite and maintain a plasma within the etching chamber; iv. A controller configured (e.g., programmed) to: a. Control the gas delivery system to stop the injection of at least one of said one or more reactants, thereby causing the decrease of the concentration of said at least one reactant; and b. Ignite a plasma within the etching chamber for a time period such that the plasma is present during the decrease of the concentration of said at least one reactant.

In embodiments, the system may be configured (e.g., programmed) to execute the steps of the method according to any embodiments of the first aspect. This embodiment provides the advantage of enabling the system to perform the method with precision and repeatability.
Any feature of the second aspect may be as correspondingly described in any embodiment of the first aspect.

In the third aspect, the present invention relates to a computer program product comprising instructions to cause the system of the second aspect to execute the steps of the method of the first aspect.
Any feature of the third aspect may be as correspondingly described in any embodiment of the first or second aspect.

In the fourth aspect, the present invention relates to a computer-readable medium having stored thereon the computer program product of the third aspect.

Any feature of the fourth aspect may be as correspondingly described in the third aspect.

It is an advantage of embodiments of the present invention that a method for dry etching a compound comprising at least two metals can be achieved, where the etching rates of the individual metals are independently controlled via a new lever. Advantageously, this permits, for instance to bring these etching rates closer to one another than would typically be achieved with classical plasma-based dry-etching. Alternatively, the method of the present invention can be used to tailor the post-etch composition of compound to one's needs. It is yet another advantage of embodiments of the present invention that the method can be applied to compounds of any crystallinity, i.e., that are amorphous or crystalline, making the invention applicable to a wide range of material types.

It is an advantage of embodiments of the present invention that the method can be used on compounds of any conductivity, from dielectric materials to superconductors. It is an advantage of embodiments of the present invention that the method can be used to form conductive elements of semiconductor devices, including metal interconnects for future nodes smaller than 2nm, and can be applied to the patterning of various types of memories such as MRAM, FeRAM, RRAM, and devices used in quantum computing.

It is an advantage of embodiments of the present invention that it can help to prevent the formation of a blocking layer and maintains a high etch rate. It is a further advantage of embodiments of the present invention that the method allows for patterning of metal compounds layers.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

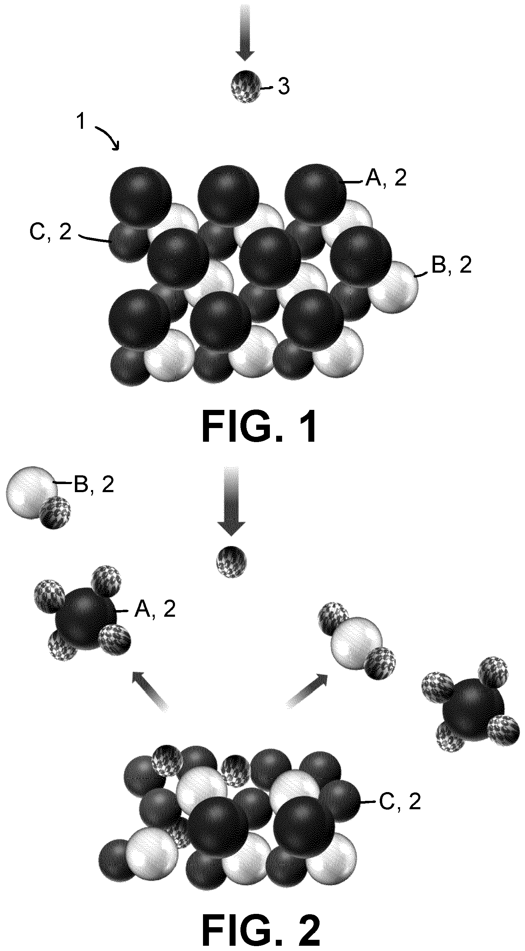

Fig.1 is a schematic representation of a three-element compound comprising at least two metals before exposure to a plasma according to either the prior art or the present invention.
Fig.2 is a schematic representation of the initial stage of etching a compound with reactant exposure according to the prior art.
Fig.3 is a schematic representation of the etching process with one element predominantly removed, leaving a surface of mostly remaining elements and reactant according to the prior art.
Fig.4 is a schematic representation of a worst-case scenario where deposition occurs on the modified compound surface during the etching process according to the prior art.

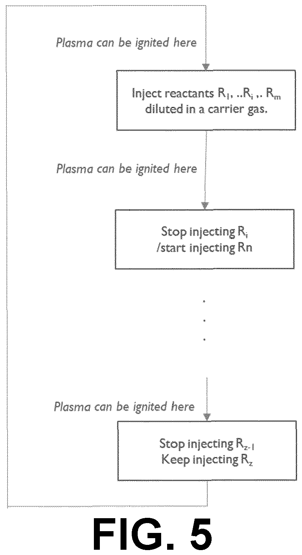

Fig.5 is a flow chart of an etching process according to embodiments of the present invention.

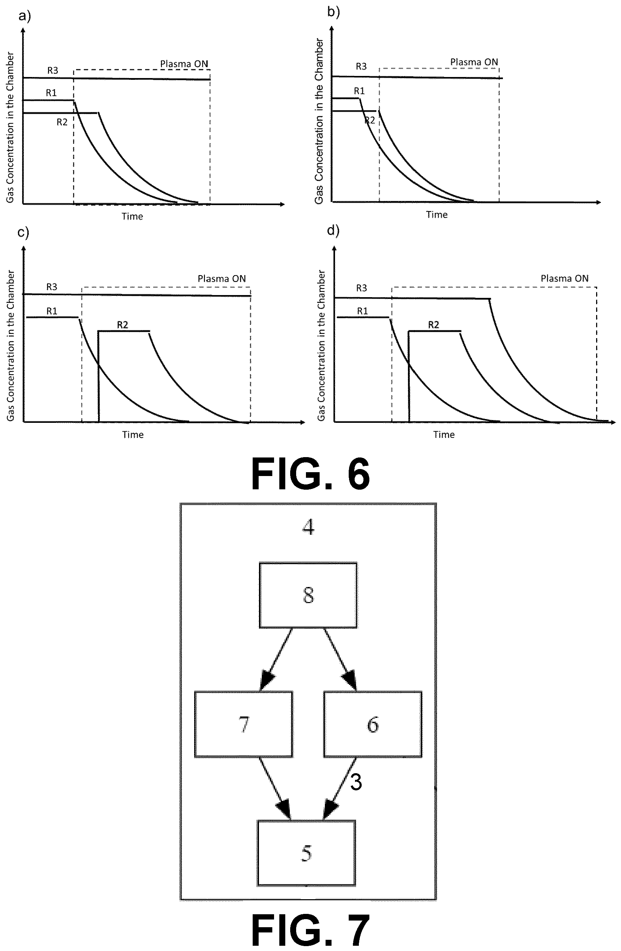

Fig.6 is a series of graphs plotting the gas concentration in the chamber as a function of process time according to four embodiments of the present invention.
Fig.7 is a schematic representation of a system for dry etching a compound according to embodiments of the present invention.

In the different figures, the same reference signs refer to the same or analogous elements.

### Detailed description of Illustrative Embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Aspects of the present invention relate to a method and system for dry etching a compound comprising at least two metals (2), as well as a computer program product and a computer-readable medium for executing the method. The method is particularly advantageous for etching metal compounds in a controlled manner to fabricate semiconductor devices, including advanced memory technologies and quantum computing devices. We now refer to Figs. 1 and 7.

In the first aspect, the present invention relates to a method for dry etching a compound (1) comprising at least two metals (2), the method comprises the following steps:
a. Injecting one or more reactants (3) and a carrier gas into an etching chamber (5) comprising the compound (1), wherein each of the metals (2) can be etched by a plasma of at least one of said reactants (3),
b. Stopping the injection of at least one of said one or more reactants (3), thereby causing a decrease of the concentration of said at least one reactant (3).
c. Igniting a plasma within the etching chamber (5) for a time period such that the plasma is present during said decrease.

As used herein, and unless otherwise specified, the term "compound comprising at least two metals" refers to a material that comprise two or more distinct metallic elements, and eventually other non-metallic elements, chemically bonded together. This includes, but is not limited to, mixed metal oxides, mixed metal nitrides, mixed metal oxynitrides, mixed metal carbides (e.g., Max-phase materials), mixed metal oxycarbides, mixed metal carbonitrides, mixed metal oxycarbonitrides, metal alloys (e.g., high entropy alloys), intermetallic compounds, and metal matrix composites where the metallic elements are present in any proportion. Preferably the at least two metals represent together at least 50 at.%, preferably at least 75 at.%, more preferably at least 90 at.%, and most preferably 100 at.% of the compound.

Preferably, each of said at least two metals forms, upon reaction with its primary reactant, an etch product having a boiling point below 600°C. Preferably, each of said at least two metals is selected from alkaline earth metals, transition metals, and post transition metals. Each of said at least two metals is preferably not gold, silver, palladium, or copper, as they take very long to etch. Each of said at least two metals is preferably selected from, but not limited to, the list consisting of Zn, Ga, In, Mg, Cr, Al, Mo, Ru, Ti, Ta, Zr, Hf, Sc, V, Nb, W, Co, Ni, and Sn. Specific embodiments of such compounds may include intermetallic compounds like NiAl and semiconducting metal oxides such as MgₓZn₁₋ₓO and IGZO (Indium Gallium Zinc Oxide). The number of metals in the compound is preferably from 2 to 5. The number of chemical elements in the compound is preferably from 2 to 5.
The compound can be present in any shape but is typically present as a layer. The present invention is useful for any thickness. The thickness of the compound, e.g., of the layer, is preferably from 0.1 nm to 1000nm.

As used herein, and unless otherwise specified, the term "reactants" refers to chemical substances that are introduced into the etching chamber and are capable of reacting with the compound under plasma conditions. These reactants may be in gaseous form and can comprise, but are not limited to, H₂; CH₄; O₂; CO; CO₂; SO₂; CH₄; N₂; N₂O; NH₃; halogen-containing gases such as: Cl₂, Br₂, F₂, BCl₃, SF₆, SiF₄, NF₃, CₓF_{y} (e.g., CF₄ or C₄F₈), and CHₓF_{y} (e.g., CH₃F). The number of injected reactants is typically from 1 to 8, and is preferably from 2 to 5.

The one or more reactants (3) may be two or more reactants (3), allowing for more precise control over the etching process. In embodiments, the timing of step b may be determined based on the etching rates of each metal in the presence of its primary reactant when the plasma is ignited. For instance, the one or more reactants (3) may be two or more reactants (3), allowing for more precise control over the etching process. In embodiments, the timing of step b may be determined based on the etching rates of each metal in the presence of its primary reactant when the plasma is ignited, such that the primary reactant of the metal having the highest of said etching rates is stopped the earliest and the stopping time increases for primary reactants of metals having successively lower said etching rates. This prioritizes the etching of metals based on their reactivities. To determine which metal has the highest reactivity with a reactant, one or both of the experiments 1 and 2 can, for instance, be performed. In embodiments where at least one of the reactant is the primary reactant for two or more metals, the timing of step b for each of the other reactants is preferably set to be earlier than for said at least one reactant being the primary reactant for two or more metals. The timing of step b for each of said other reactants may be determined based on the etching rates of each metal for which said other reactants are the primary reactants, when the plasma is ignited, such that the primary reactant of the metal having the highest of said etching rates is stopped the earliest and the stopping time increases for primary reactants of metals having successively lower said etching rates.

In embodiments, the carrier gas may comprise one or more of Ar, He, Xe, N₂, and O₂. In preferred embodiments, the carrier gas may comprise one or more of Ar, He, and Xe, as they are not chemically reactive. Preferably, the carrier gas is not reactive toward the compound. If the carrier gas is also one of the reactant gas, it is preferably the primary reactant responsible to etch the element with slowest etch rate in presence of its primary reactant. Preferably, the carrier gas is different from any of the reactants. Preferably, the carrier gas is more electropositive than any of the reactants.

As used herein, and unless otherwise specified, the term "etching chamber (5)" refers to a sealed environment, typically within an etching system (4), where the etching process takes place. This chamber is designed to contain the compound (1) to be etched and to allow for the controlled introduction of reactants (3), carrier gases, and the generation of plasma. The etching chamber may include various components such as gas inlets, exhaust systems, and electrodes for plasma generation. It is typically constructed from materials that are resistant to the corrosive effects of the etching process.

During the performance of the method, the injection of at least one of the reactants (3) is stopped in step b. This is visible in each of the embodiments depicted in Fig. 6. In embodiments, two or more reactants are injected in step a and the injection of at least two of these reactants is stopped in step b. In other words, step b may consist in stopping the injection of at least two of the reactants (3), thereby causing the decrease of each of the concentrations of said at least two of the reactants (3), and wherein step c. consists in igniting the plasma within the etching chamber (5) for a time period such that the plasma is present during each of said decreases. This is also what is depicted in all embodiments of Fig.6. Typically, when more than one reactant is stopped in step b, they are not stopped simultaneously. In embodiments, all of the reactants injected in step a are stopped in step b. This is depicted in Fig. 6 d). In other embodiments, all but one of the reactants injected in step a, are stopped in step b. This is depicted in Figs. 6a) to 6c).

In a plasma etching system, a vacuum pump is used to maintain the low pressure required for plasma generation. Once the injection of a reactant is stopped, the existing molecules of the reactant in the chamber are gradually removed by the vacuum system, which causes the decrease in concentration.

In step c, the plasma is ignited. As used herein, and unless otherwise specified, the term "igniting a plasma" refers to the process of initiating a plasma state within the etching chamber (5) by applying energy to the gas mixture containing the reactants (3) and carrier gas. This energy can be supplied through various means such as radio frequency (RF) power, microwave power, or direct current (DC) discharge. The plasma consists of a collection of particles including electrons, ions, and neutral species that are capable of interacting with the compound (1) to effect etching.

The plasma is ignited for a time period such that the plasma is present during the decrease of the concentration of at least one reactant. Preferably, the plasma is ignited for a time period such that the plasma is present during the decrease of the concentration of all reactants which injections have been stopped in step b. This is depicted in all embodiments of Fig. 6. It is not necessary for the plasma to be on, i.e., ignited, during the whole decrease of at least one reactant. It is sufficient if the plasma is ignited for at least part of the decrease of at least one reactant (3). This is not depicted in fig. 6. Preferably, the plasma is present during the entire decrease of the concentration of at least one reactant (3). The plasma is typically ignited before or simultaneously with the stopping of the injection of at least a reactant (3), as depicted in all embodiments of Fig. 6. However, it can also be ignited after the stopping occurred (not depicted). Fig. 5 shows times where the ignition of the plasma can be started in embodiments of the first aspect. As shown in this figure, the plasma can be started at any time as long as it is present during the decrease of a reactant (3).

As used herein, and unless otherwise specified, the term "time window extending from 500 ms before and 500 ms after" refers to a specific period during which the ignition of the plasma is initiated relative to the stopping of the injection of one of the reactants (3). This time window defines a range of acceptable timings for starting the plasma ignition, where "500 ms before" indicates that the plasma can be ignited up to half a second before the reactant injection is stopped, and "500 ms after" indicates that the plasma can be ignited up to half a second after the reactant injection has ceased. Preferred embodiments specify narrower time windows, such as from 250 ms before and after, or from 100 ms before and after. For instance, the injection can be stopped at the same time as the ignition of the plasma is started. Stopping the injection of one of the reactants approximatively at the same as when the plasma is started frequently give good results. However, reactants can also be stopped before or after, even longer than 500 ms before or after, depending on the particular case at hand.

In embodiments, the gas injection of each reactant (3) is maintained for a period of at least 10 ms, more preferably at least 50 ms, and even more preferably at least 100 ms. This preference is due to the fact that longer gas injection times are more reproducible, which lead to better control of the etching process.

The magnitude of the flow rates of the two or more reactants (3) during their injection period may be determined based on the etching rates of each metal (2) in the presence of the reactant (3) most responsible for its etching rate when the plasma is ignited, e.g., in the presence of said two or more reactants (3) when the plasma is on. In embodiments where at least one of the reactant is the primary reactant for two or more metals, the flow rate of each of the other reactants during their injection period is preferably set to be lower than for said at least one reactant being the primary reactant for two or more metals. The relative magnitude of the flow rates of each of said other reactants during their injection period may be determined based on the etching rates of each metal for which said other reactants are the primary reactants, when the plasma is ignited, such that the primary reactant of the metal having the highest of said etching rate is injected at the lowest flow rate, and the flow rates increase for primary reactants of metals having successively lower etching rates. Each reactant (3) which injection is stopped in step b may be injected at a gas flow of from 0.1 sccm to 1500 sccm, with preferred ranges provided for more precise control. As used herein, and unless otherwise specified, the term "gas flow of from 0.1 sccm to 1500 sccm" specifies the range of flow rates at which the reactants (3) are introduced into the etching chamber (5). The unit "sccm" stands for standard cubic centimeters per minute and is a measure of the volumetric flow rate of a gas, standardized to a set of reference conditions of temperature and pressure. Preferred embodiments specify narrower ranges such as from 0.5 sccm to 500 sccm, from 1 sccm to 200 sccm, or from 2 sccm to 50 sccm. A gas flow of from 0.1 to 50 sccm is most typically useful for most reactants (3). In embodiments, a primary reactant (3) of the metal (2) having the lowest etching rate in presence of its primary reactant (3) when the plasma is ignited may be injected without interruption, i.e., without performing step b. This is especially useful if that lowest etching rate is at least twice smaller, such as at least four times smaller, than the etching rate of the metal having the second lowest etching rate in presence of its primary reactant (3) when the plasma is ignited. In embodiments, the primary reactant of the metal having the lowest etching rate may preferably be injected without interruption at a gas flow of from 100 to 1500 sccm if that etching rate is at least two times, such as at least four times smaller than the etching rate of the metal having the second lowest etching rate in presence of its primary reactant when the plasma is ignited. In embodiments, where a reactant is the primary reactant for two or more metals, this reactant may be injected without interruption at a higher flow rate than the other reactants.

The method may further comprise a step p, before step a, of determining the relative etching rates of each metal (2) in the presence of the reactant (3) most responsible for its etching rate, e.g., in the presence of said two or more reactants (3), when the plasma is ignited. This step is optional because the behavior of each metal in presence of its primary reactant when the plasma is ignited may be known from the scientific literature or from past experience. However, this embodiment provides the advantage of enabling a more informed approach to the etching process by better understanding the etching rates beforehand, which could lead to better results.

In embodiments, the compound may be amorphous. Although the present invention is useful for all kinds of structures, including crystalline structures, amorphous compounds are advantageous, especially when the thickness of the material layer is relatively low, such as less than 10 nm. The present invention is advantageous for all metal compounds and for all thickness. However, because it is plasma-based, the method may nevertheless inflict minor damage, amounting to a few angstroms or nanometers, to the crystalline lattice of materials. This becomes more problematic when dealing with crystalline material layers that are only a few nanometers thick.

In embodiments, the compound may form a layer which is at least 10 nm thick and is crystalline.

The compound may form a conductive element of a semiconductor device, such as a metal interconnect, or be part of memory devices, or quantum computing devices. As used herein, and unless otherwise specified, the term "conductive element of a semiconductor device" refers to a component within a semiconductor device that is designed to conduct electrical current. This includes, but is not limited to, metal interconnects, electrodes, gates, and contact pads. These conductive elements can be made from various conductive materials, including metals and metal alloys, and are integral to the functionality of semiconductor devices such as transistors, diodes, and integrated circuits. As used herein, and unless otherwise specified, the term "Metal (2) interconnect" refers to a conductive pathway within a semiconductor device that electrically connects different components or regions of the device. These interconnects are typically made of metals or metal alloys and are used to establish electrical continuity within the device. The term "< 2nm node" refers to semiconductor technology nodes with feature sizes smaller than 2 nanometers, indicating advanced semiconductor manufacturing processes that produce devices with extremely fine geometries.

As used herein, and unless otherwise specified, the term "Memory" encompasses various types of data storage technologies used in semiconductor devices, including but not limited to Magnetoresistive Random-Access Memory (MRAM), Ferroelectric RAM (FeRAM), Resistive RAM (RRAM), and spin-torque memory devices. The term "quantum computing device" refers to a computing system that utilizes the principles of quantum mechanics, such as superposition and entanglement, to perform operations on data.

The conductive element may also be a superconductor. As used herein, and unless otherwise specified, the term "superconductor" refers to a material that can conduct electricity without resistance below a certain critical temperature. Superconductors are used in various applications, including conductive elements in semiconductor devices, where they enable highly efficient electrical conduction. Non-limiting examples of compounds (1) are MgₓZn₁₋ₓO, IGZO, or NiAl. The compound is not necessarily a conductor and could be a semiconductor compound, such as IGZO, or be a dielectric.

The etching process may be conducted in cycles, with each cycle comprising steps a. through c., and, for instance, each cycle may remove less than 1 nm of the compound (1). This enables precise material removal with minimal etching per cycle.

As used herein, and unless otherwise specified, the term "each cycle removes less than 1 nm of the compound (1)" indicates that the amount of material etched away from the compound (1) during a single cycle of the etching process is less than one nanometer in thickness. This level of control allows for very fine adjustments to the etched features, which is particularly advantageous in advanced semiconductor manufacturing where feature sizes can be on the order of nanometers.

In embodiments, the method may be for patterning the compound (1).
As used herein, and unless otherwise specified, the term "patterning the compound (1)" refers to the process of creating a specific geometric pattern on the surface of the compound (1) by selectively removing material through etching.

In the second aspect, the system (4) for dry etching a compound (1) comprises an etching chamber (5), a gas delivery system (6), a plasma generation system (7), and a controller (8). The controller (8) is configured to control the gas delivery system (6) to stop the injection of at least one of the reactants (3) and to ignite a plasma within the etching chamber (5) for a time period such that the plasma is present during the decrease of the concentration of said at least one reactant (3).

As used herein, and unless otherwise specified, the term "system (4) for dry etching" refers to an apparatus or setup designed to perform the process of dry etching on a compound (1) comprising at least two metals (2). This system includes various components such as an etching chamber (5), gas delivery system (6), plasma generation system (7), and a controller (8) that work together to facilitate the etching process. Fig. 7 provides a schematic representation of the system (4), showing the components and their arrangement within the etching system.

The system (4) may be configured to execute the steps of the method according to any embodiments of the first aspect, thereby enabling the system (4) to perform the method with precision and repeatability.

In the third aspect, the present invention relates to a computer program product comprising instructions to cause the system (4) of the second aspect to execute the steps of the method of the first aspect. As used herein, and unless otherwise specified, the term "computer program product" refers to a software product that contains instructions which, when executed by a computer or a controller (8), cause the system (4) to perform specific operations. This product can, for instance, be distributed on a physical medium like a CD-ROM or as a digital download.

In the fourth aspect, the present invention relates to a computer-readable medium having stored thereon the computer program product of the third aspect. As used herein, and unless otherwise specified, the term "computer-readable medium" refers to any data storage device that can store data which can thereafter be read by a computer system. This includes, but is not limited to, hard drives, solid-state drives, CDs, DVDs, USB flash drives, and memory cards. The computer-readable medium may have the computer program product of claim 21 stored on it, which contains instructions for executing the steps of the method of claim 1 when run by a system (4) for dry etching.

Example: composition-consistent etching of a metal compound.

In the prior art, the etching of metal compounds is typically not uniform, with some elements etching faster than others. The present invention provides an etching method that allows to reduce this tendency, or even to eliminate it. The inventors realized that each element of a metal compound has different needs in terms of ion assistance or supply of neutral species and that, as a result, each of them will require a different neutral over ion flux ratio (for each neutral and ion type).

In this non-limiting example, one way to implement the method will be illustrated, Assuming that no foreknowledge of the etching rates of the various components of a metal compound is available. We will consider an alloy with components (A, B, C), each of them with different requirements (chemical reactant, ion assistance, etc.) to be etched. R1, R2 and R3 are the reactants injected to etch each component of the alloy. For clarity and simplicity, let's consider that R1 is mostly responsible for etching of A, R2 for B and R3 for C. In other words, R1, R2, and R3 are the primary reactants for A, B, and C respectively.
The difficulty arise from the fact that different metals of the metal compound will have different needs in terms of neutral species and in terms of ions to achieve an optimal etching speed.

The inventors realized that the different etch requirements would translate as follow in terms of process:

**Table 1: Correspondence between etch requirements and injection scenarios as shown in figure 6.**

| Neutral needs | Corresponding gas flow | Ion needs | Corresponding plasma time | Neutral/lon ratio | Corresponding graph/ injection scenario |
|---|---|---|---|---|---|
| High | Gas injection with plasma ON | High | Long | Medium | R3 in graphs a, b, c |
| | | Medium | Medium | High | |
| | | Low | Short | Very high | |
| Medium | Short gas injection with plasma ON | High | Long | Low | R2 in graphs a, c, d |
| | | Medium | Medium | Medium | R3 in graph d |
| | | Low | Short | High | |
| Low | Reduce gas concentration while plasma is ON | High | Long | Very low | R1 in all graphs |
| | | Medium | Medium | Low | R2 in graph b |
| | | Low | Short | Medium | |

The inventors realized that the neutral over ion flux ratio, and thereby the relative etching rates of each metal, can be controlled by letting the concentrations of one or more reactants decay in the plasma phase. During one decay, the flux of neutrals decreases after the injection of the gas has been stopped as they are either being consumed by reactions or being pumped out. The timing of this stopping with respect to the ignition period of the plasma will, therefore, determine the etching that will be achieved during that cycle for a metal for which the reactant stopped is the primary reactant. Hence, by having the plasma remaining ignited during a period of reactant decay, one has at its disposition a new control lever for adapting the etching rate of A, B, and C. The most typical use of this new control lever is for achieving a more equal etching rate for A, B, and C than would otherwise be possible. This is the use we will discuss in this example. Other uses can, of course, also be envisioned.

For the present example, we will assume that the carrier gas is more electropositive than R1, R2, and R3. As the neutral flux decreases, the ion flux will increases. The inventors reasoned that, in the aforementioned scenario, the etching rates of A, B, and C can be brought closer to equality by taking into account the following:
- when a low neutral/ion ratio is preferred, the injection of the corresponding gas is preferably stopped before (or simultaneously with) the plasma ignition.
- When a high neutral/ion ratio is preferred, the corresponding gas injection is preferably sustained all along the plasma step (or stopped slightly before the end).
- When a moderate neutral/ion ratio is preferred, injection can be sustained for as much time as needed during the plasma step to ensure the need for reactive neutrals before the concentration decays and the remaining plasma time ensures the needs for energetic ions. If both needs are low, then the gas injection could start during the plasma step, thereby shortening the injection of neutrals and the ion bombardment of a surface saturated with reactants.

To accommodate excessive reactivity of a reactant with one component of the alloy, very short pulses could be injected at low concentrations as illustrated by R1 in figure 6b.

The graphs a, b, c and d of Figure 6 would represent the four most common scenarios. Other much less common scenarios are not represented here, as the capabilities they offer would often be redundant with another available tuning parameter such as gas flows or RF source power. We now refer to Fig.6 where four typical scenarios are depicted. To establish under which scenario of the four scenarios shown in Fig. 6 a particular process could fall, the following approach can, as an illustrative example, be applied.

### 1) Experiment 1: Define respective etch rates.

In this example, we assume that the respective etch rates of A, B, and C is presence of respectively R1, R2, and R3 are not known. This is the worst case scenario. To determine the respective etch rates, one can proceed as follows.
- Inject one reactant at an arbitrary flow rate (though it is recommend keeping it in the low range such as 2-50 sccm, to limit the movements of the pressure-regulating valve),
- Strike the plasma at the same time as the injection is being stopped (as an example), and
- Keep the plasma ON for an arbitrary amount of time (e.g., 3 seconds).

By measuring the composition of the alloy pre- and post-etching, one can see how much the proportion of each component evolved (accumulation of some elements, depletion of others). This allows to determine the etching of what metal that reactant is most responsible for. It also gives an indication of the etching rate of each metal in presence of that reactant.

This experiment is repeated for each reactant.

### 2) Experiment 2: Refine respective etch rates.

To have a more precise idea of the relative etching rates of A, B, and C during an etching period where all three reactants are present, the following experiment can be performed.
- Inject all three reactants at the same time and at the same arbitrary flow rate (e.g., in the range 2-50 sccm),
- Strike the plasma at the same time as the injection is being stopped (as an example) for all three reactants,
- Keep the plasma ON for an arbitrary amount of time (e.g., 3 seconds).

By measuring the composition of the alloy pre- and post-etching, one can see how much the proportion of each component evolved (accumulation of some elements, depletion of others).

### 3) Experiment 3: Dependency of etch rates with neutral and ion fluxes.

This experiment can be performed to gain a more in-depth understanding of how neutralsensitive a metal is. Indeed, the more the etching rate of a metal is neutral sensitive, the more an increase in the pressure will increase its etching rate.

For this experiment, one can run the same experiments as above at a larger pressure (e.g. 20-40 mTorr), without changing the gas flows or power settings, then measure the composition of the alloy post-etching to refine the desired range of pressure for this process.

### 4) Experiment 4: Interactions between gases in plasma step.

Further experiments can be performed to explore how the presence of multiple reactants influence etching during the plasma step. For instance, a gas injection scheme similar to graph c or d can be performed to ensure that at least two gases are present in the reactor at the same time. The composition can then be measured post-etching.

### 5) Experiment 5: Definition of gas concentration and injection stops.

To maintain a same composition as much as possible during etching, the slowest elements to etch preferably have their corresponding reactant flow set high compared to the others. Furthermore, their injection is preferably sustained longer than the others (again, more gas needed to reach an etch rate equivalent to the one of the other elements). Following this logic and the results of the previous experiments in terms of composition and etch rate results, gas injection timings and relative concentrations can be adjusted.

Depending on one prior knowledge of the behaviors of A, B, and C in presence of R1, R2, and R3, a combination of one or more of the above experiments will help selecting the most relevant of the scenarios of figure 6 for performing an etching process.

### 6) Experiment 6: Impact of ion fluence on composition of the alloy.

For this experiment, a longer plasma durations (5 to 10 seconds instead of the initial 3 seconds, for instance) can be used in the chosen scenario to assess if more ions are needed for a certain element or not.

Running an experiment for determining what power is optimal is not envisioned here because the experiment 3 with pressure also indicates whether molecules of each reactant should be heavily dissociated (high power) or not (low power), and experiment 6 will indicate if more ions are needed. If an optimization of power is envisaged, then a good moment to implement it is right after experiment 3, while doing experiment 4.

It is recommended keeping the gas flows of each reactant low compared to the carrier gas flow. Indeed, the total gas flow is not conserved in this process when the injection stops, resulting in movement of the pressure-regulating valve (closing more). The same valve would also have to move (opening more) at plasma ignition as the density of species (and thus global pressure) increases at this moment (molecules are dissociated into several fragments). By keeping the injected gas flows low relative to the carrier gas flow, these moves can be minimized and even compensated with dedicated optimizations. Going for large reactant gas flows would result in large moves of the valve and reproducibility of the results would suffer. Delays of injection would be the most adequate parameter to use to set the relative concentrations of these gases if large flow ratios would be used.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for dry etching a compound (1) comprising at least two metals (2), the method comprising:
a. Injecting one or more reactants (3) and a carrier gas into an etching chamber (5) comprising the compound (1), wherein each of the metals (2) can be etched by a plasma of at least one of said reactants (3),
b. Stopping the injection of at least one of said one or more reactants (3), thereby causing a decrease of the concentration of said at least one reactant (3), and
c. Igniting a plasma within the etching chamber (5) for a time period such that the plasma is present during said decrease.

2. The method according to claim 1, wherein said one or more reactants (3) are two or more reactants (3).

3. The method according to claim 2, wherein step b. consists in stopping the injection of at least two of the reactants (3), thereby causing the decrease of each of the concentrations of said at least two of the reactants (3), and wherein step c. consists in igniting the plasma within the etching chamber (5) for a time period such that the plasma is present during each of said decreases.

4. The method according to any one of the preceding claims, wherein the ignition of the plasma is started within a time window extending from 500 ms before and 500 ms after, preferably from 250 ms before and 250 ms after, more preferably from 100 ms before and 100 ms after, the stopping of the injection of one of the reactants (3) during step b.

5. The method according to any one of claims 2 to 4, wherein the timing of step b is determined based on the etching rates of each metal (2) in the presence of its primary reactant (3) when the plasma is ignited.

6. The method according to any one of claims 2 to 5, wherein the magnitude of the flow rates of the two or more reactants (3) during their injection period is determined based on the etching rates of each metal (2) in the presence of the reactant (3) most responsible for its etching rate when the plasma is ignited.

7. The method according to claim 5 or 6, further comprising a step p, before step a of determining the relative etching rates of each metal (2) in the presence of the reactant (3) most responsible for its etching rate when the plasma is ignited.

8. The method according to any one of the preceding claims, wherein each reactant (3) which injection is stopped in step b. is injected in step a. at a gas flow of from 0.1 sccm to 1500 sccm, preferably from 0.5 sccm to 500 sccm, more preferably from 1 sccm to 200 sccm, yet more preferably from 2 sccm to 50 sccm.

9. The method according to any one of the preceding claims, wherein the compound (1) is amorphous.

10. The method according to any one of the preceding claims, wherein the compound (1) forms a layer which is at least 10 nm thick and is crystalline.

11. The method according to any one of claims 1 to 10, wherein the compound (1) forms a conductive element of a semiconductor device.

12. The method according to any one of the preceding claims, wherein the etching process is conducted in cycles, with each cycle comprising steps a. through c..

13. A system (4) for dry etching a compound (1) comprising at least two metals (2), the system (4) comprising:
i. An etching chamber (5) configured to receive the compound (1);
ii. A gas delivery system (6) configured to inject one or more reactants (3) and a carrier gas into the etching chamber (5);
iii. A plasma generation system (7) configured to ignite and maintain a plasma within the etching chamber (5);
iv. A controller (8) configured to:
a. Control the gas delivery system (6) to stop the injection of at least one of said one or more reactants (3), thereby causing the decrease of the concentration of said at least one reactant (3); and
b. Ignite a plasma within the etching chamber (5) for a time period such that the plasma is present during the decrease of the concentration of said at least one reactant (3).

14. A computer program product comprising instructions to cause the system (4) of claim 13 to execute the steps of the method of claim 1.

15. A computer-readable medium having stored thereon the computer program product of claim 14.
